# EUROPÄISCHE PATENTSCHRIFT

(11) **EP 1 109 206 B1**
(45) Veröffentlichungstag und Bekanntmachung des Hinweises auf die Patenterteilung: **29.08.2007**
(21) Anmeldenummer: 99125131.5
(22) Anmeldetag: 16.12.1999
(51) Int. Cl.: H01L 21/00

(54) **Prozessanlage und Prozessverfahren zur Montage von Leadframes**
Apparatus and process for mounting of lead frames
Appareil et procédé de montage des cadres de connexion

(43) Veröffentlichungstag der Anmeldung: 20.06.2001
(73) Patentinhaber: Infineon Technologies AG, 81669 München (DE)
(72) Erfinder: Dirnberger, Josef, 93149 Nittenau (DE); Breu, Johann, 94372 Rattiszell (DE)
(74) Vertreter: Epping - Hermann - Fischer

(56) Entgegenhaltungen:
- US-A- 5 501 316
- US-A- 5 661 090
- PATENT ABSTRACTS OF JAPAN vol. 1998, no. 02, 30. Januar 1998 (1998-01-30) -& JP 09 266220 A (SONY CORP), 7. Oktober 1997 (1997-10-07)
- PATENT ABSTRACTS OF JAPAN vol. 004, no. 137 (E-027), 25. September 1980 (1980-09-25) -& JP 55 088339 A (HITACHI LTD), 4. Juli 1980 (1980-07-04)
- PATENT ABSTRACTS OF JAPAN vol. 014, no. 365 (E-0961), 8. August 1990 (1990-08-08) -& JP 02 130849 A (HITACHI LTD), 18. Mai 1990 (1990-05-18)

## Beschreibung

Die vorliegende Erfindung betrifft eine Prozeßanlage und ein Prozeßverfahren zur Montage von elektronischen Bauelementen auf Leadframes.

Elektronische Bauelemente wie z.B. integrierte Schaltkreise werden auf einem Trägermaterial (Leadframe) montiert, durch elektrische Leitungen mit dem Leadframe verbunden und anschließend mit einem Gehäuse versehen. Dazu werden z. B. Verfahren verwendet, die in dem US-Patent 4,887,7 58 beschrieben werden.

Üblicherweise bilden die Leadframes ein Band, welches in die Prozeßanordnung eingelegt ist. Das Band wird erst in die einzelnen Leadframes zerschnitten, wenn das elektronische Bauelement mit dem Leadframe verbunden ist.

Andererseits werden auch einzelne Leadframes verwendet, die der Prozeßanordnung einzeln zugeführt werden. Dies wird z.B. bei Leistungsbauelementen wie Leistungstransistoren durchgeführt. Dazu wird ein Leadframe auf einer Arbeitsplatte abgelegt und positioniert, und ein Transportsystem schiebt das Leadframe über die Arbeitsplatte von einer Bearbeitungsstation zu der nächsten Bearbeitungsstation.

Das Transportsystem besteht z.B. aus einer Klemme bzw. aus Zangen, die den Leadframe greifen. Ebenso kann das Transportsystem aus Transportstiften bestehen, die in Löcher gesteckt werden, die sich in dem Leadframe befinden. Von diesen Klemmvorrichtungen sind eine ganze Reihe entlang der Prozeßanordnung vorgesehen. Ein derartiges Transportsystem ist zum Beispiel aus dem Patent Abstract of Japan 09 266 220 bekannt, bei dem ein Leadframe auf eine Förderungsschiene gelegt und über ein über der Förderungsschiene angebrachtes und mit Stiften versehenes Förderband bewegt wird.

Nach dem Greifen der Leadframes werden alle Leadframes, die sich auf der Arbeitsplatte befinden, ein Stück auf der Arbeitsplatte vorgeschoben. Dieser Verschiebevorgang kann sowohl simultan, als auch asynchron durchgeführt werden. Es werden die Klemmen wieder gelöst und das Transportsystem fährt an die ursprüngliche Position zurück, an der bereits ein neuer Leadframe in die Prozeßanordnung eingelegt ist.

Erneut werden alle Leadframes gegriffen und ein Stück auf der Arbeitsplatte vorgeschoben.

Problematisch ist hierbei, daß bei dem Greifen eines bereits vorgeschobenen Leadframes eine Justierungenauigkeit auftreten kann. Ist dies der Fall, so kann die Klemmvorrichtung den Leadframe nicht exakt an der vorgesehenen Stelle greifen und es kommt zu Dejustierungen und Fehlproduzierungen.

Üblicherweise durchläuft ein Leadframe auf der Arbeitsplatte einen Prozeßschritt, bei dem Lötmittel an genau vorherbestimmten Positionen auf den Leadframe aufgebracht wird. Anschließend wird in einem Ofen bei einer Temperatur von 200° bis 500° Celsius ein elektrisches Bauelement auf dem Leadframe positioniert und angelötet. Auch hierbei ist eine exakte Positionierung des elektrischen Bauelementes erforderlich, um Fehlproduzierungen zu vermeiden.

Besonders nachteilig wirkt sich die hohe Temperatur zwischen 200° und 500° Celsius auf die mechanische Justiergenauigkeit der Klemmen zu den Leadframes aus. Durch die Wärmeausdehnung, die das Transportsystem und der Leadframe erfahren, kommt es zu Dejustierungen. Eine Fehlerbehebung ist im heißen Zustand nur sehr schwer möglich.

Aus der US 5,661,090 ist ein Verfahren und eine Vorrichtung zur Herstellung von keramischen Halbleitergehäusen angegeben bei dem auf einem Transportband Leadframe-Träger befestigt sind, auf die Leadframes gelegt und über Positionierungsstifte bezüglich einer Positionierungsplatte justiert werden. Anschließend wird ein Keramiksubstrat anhand des Leadframes zentriert und auf diesem vorläufig befestigt. Die Positionierungsstifte werden entfernt und der Leadframe-Träger wird mit dem Leadframe und dem Substrat auf dem Transportband in einen Ofen gefahren. Nachteilig ist dabei, dass der Leadframe durch die Positionierungsstifte nur bezüglich der Positionierungsplatte justiert wird und das auch nur am Anfang, nicht aber bezüglich des Leadframe-Trägers, sodass mehrere Bearbeitungsstationen nicht durchlaufen werden können, ohne den Leadframe neu justieren zu müssen.

Es ist die Aufgabe der Erfindung, eine Prozeßanlage und ein Prozeßverfahren für das Verbinden von elektronischen Bauelementen mit einem Leadframe anzugehen, wobei Fehlprozeßierungen vermieden werden.

Erfindungsgemäß wird diese Aufgabe durch die Merkmale der in Anspruch 1 angegebenen Prozeßanordnung gelöst.

Weiterhin wird die gestellte Aufgabe durch das in Anspruch 5 angegebene Verfahren gelöst

Bevorzugte Weiterbildungen sind Gegenstand der jeweiligen Unteransprüche.

In einer vorteilhaften Ausprägung der erfindungsgemäßen Anordnung befindet sich das Transportband 1 zumindest teilweise in einer Temperaturkammer. Durch diese Anordnung ist es möglich, den Leadframe einem Temperaturschritt zu unterziehen, bei dem ein elektronisches Bauelement mit dem Leadframe vebunden, bzw. verlötet werden kann.

In einer weiteren vorteilhaften Ausprägung der erfindungsgemäßen Anordnung befindet sich in dem Leadframe ein Loch oder eine Indexbohrung, an dem die Halterung justiert und/oder befestigt ist. Durch das Loch ist ein sicheres Greifen des Leadframes möglich. Weiterhin kann das Loch als Justiermarke verwendet werden, in dem z.B. ein Stift durch das Loch gesteckt wird, um so ein Verrutschen des Leadframes zu verhindern.

Durch die erfindungsgemäße Anordnung ist es möglich, den Leadframe auf dem Transportband zu transportieren und ein elektrisches Bauelement mit dem Leadframe zu verbinden, während sich der Leadframe in justierter Art und Weise auf dem Transportband befindet und dort arretiert ist.

Durch die erfindungsgemäße Anordnung ist es außerdem möglich, den Leadframe in justierter Art und Weise auf dem Transportband zu belassen, während der Leadframe von einer vorhergehenden Bearbeitungsstation zu der Bearbeitungsstation zum elektrischen Kontaktieren weiter transportiert wird. Das elektrische Kontaktieren (Bonden) erfordert ebenfalls genau wie das mechanische Verbinden (Auflöten) eine exakte Justierung, die durch die Justierung des Leadframes zu dem Transportband und zu der Halterung gegeben ist.

Weiterhin ist es vorteilhaft, die Halterung als Stift vorzusehen, auf den der Leadframe aufgesteckt wird. Dadurch wird das Verrutschen des Leadframes verhindert.

Das erfindungsgemäße Verfahren hat den Vorteil, daß der Leadframe eine genau vorherbestimmte Position auf dem Transportband einnimmt und diese Position relativ zu dem Transportband während eines Teils oder der gesamten Prozessierung beibehält.

In einer vorteilhaften Weiterbildung des erfindungsgemäßen Verfahrens durchläuft das Transportband mit dem aufgelegten Leadframe eine Temperaturkammer. Durch diesen Verfahrensschritt ist es möglich, den Leadframe einem Prozeßschritt zu unterziehen, bei dem eine erhöhte Temperatur verwendet wird. Dies ist z.B. bei dem Auflöten eines elektronischen Bauelements der Fall.

In einer weiteren vorteilhaften Ausprägung des erfindungsgemäßen Verfahrens wird ein Verbindungsmittel auf dem Leadframe aufgebracht. Dabei kann es sich beispielsweise um Lötmaterial handeln, mit dem in einer Temperaturkammer ein elektrisches Bauelement mit dem Leadframe verlötet wird.

Eine weitere vorteilhafte Ausprägung des erfindungsgemäßen Verfahrens sieht vor, daß ein Bauelement mit Hilfe des Verbindungsmittels mit dem Leadframe verbunden wird.

Ein weiterer vorteilhafter Verfahrensschritt sieht vor, daß das Transportband um eine frei wählbare Strecke verfahren wird. Durch diesen Verfahrensschritt ist es möglich, den Leadframe, der mit der Halterung an dem Transportband befestigt ist, in einer frei wählbaren Art und Weise so zu positionieren, daß z.B. das Verbindungsmittel, das elektrische Bauelement und/oder eine elektrische Kontaktierung an einer vorbestimmten Position auf dem Leadframe angebracht werden kann.

Ein weiterer vorteilhafter Verfahrensschritt sieht vor, daß das Leadframe mit einem elektrischen Bauelement elektrisch verbunden wird. Durch diesen Verfahrensschritt werden beispielsweise Bonddrähte zwischen dem elektrischen Bauelement und dem Leadframe angebracht. Eine weitere vorteilhafte Ausprägung des erfindungsgemäßen Verfahrens sieht vor, daß in dem Leadframe ein Loch angeordnet ist, an dem die Halterun justiert und/oder befestigt wird. Durch dieses Vorgehen ist es möglich, den Leadframe anhand des Loches auszurichten und mit der Halterung zu greifen, so daß der Leadframe nicht auf dem Transportband verrutschen kann.

Durch die erfindungsgemäße Anordnung und das erfindungsgemäße Verfahren ist es möglich, die Leadframes in kaltem Zustand also außerhalb einer Temperaturkammer auf das Transportband aufzulegen. Nachdem die Leadframes die Temperaturkammer verlassen haben, können sie im erkalteten Zustand wieder von dem Endlostransportband entfernt werden. Dies hat den Vorteil, daß jeder Leadframe nur einmal, und dies nicht im heißen Zustand innerhalb der Temperaturkammer, sondern außerhalb beim Auflegen auf das Transportband positioniert und justiert werden muß. Besonders vorteilhaft wirkt sich dabei aus, daß die Wärmeausdehnung innerhalb der Temperaturkammer keine Justierprobleme verursacht.

Ein weiterer Vorteil der erfindungsgemäßen Anordnung und des erfindungsgemäßen Verfahrens ist, daß eine Formiergasspülung in der Temperaturkammer wesentlich einfacher, konstanter und kontrollierbarer ausgeführt werden kann.

Durch ein Bilderkennungssystem, das eine optische Zentrierung durchführt, ist eine flexible Anpassung verschiedener Leadframes an das Endlostransportband 1 möglich. Weiterhin wird dadurch eine wahlfreie Positionierung und eine Nachjustage des Leadframes in jedem Betriebszustand und jedem Bearbeitungsschritt ermöglicht.

Ausführungsbeispiele der Erfindung werden nachfolgend anhand der Zeichnung dargestellt und erläutert.

In den Figuren zeigen:
- Figur 1: einen vereinzelten Leadframe;
- Figur 2: ein Transportsystem durch eine Montageprozeßanlage gemäß dem Stand der Technik;
- Figur 3: das Transportsystem gemäß Figur 2 in einer Draufsicht;
- Figur 4: die Seitenansicht eines Transportsystems in einer Montageprozeßanlage gemäß der Erfindung;
- Figur 5: die Montageprozeßanlage aus Figur 4 in einer Draufsicht.

In den Figuren bezeichnen gleiche Bezugszeichen gleiche oder funktionsgleiche Elemente.

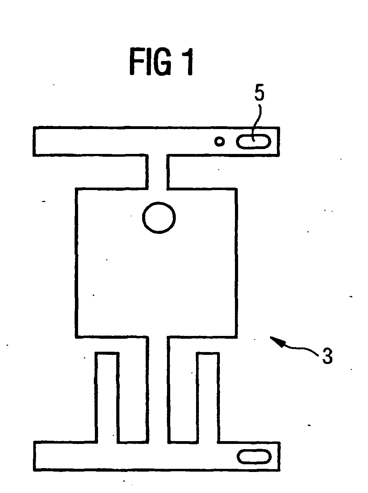

In Figur 1 ist exemplarisch ein Leadframe 3 dargestellt. In dem Leadframe 3 befindet sich ein Loch 5. Üblicherweise befinden sich die Einzelleadframes aus Figur 1 in einem Band, bei dem sich links und rechts neben dem Leadframe 3 entsprechend weitere gleichartige Leadframes anschließen.

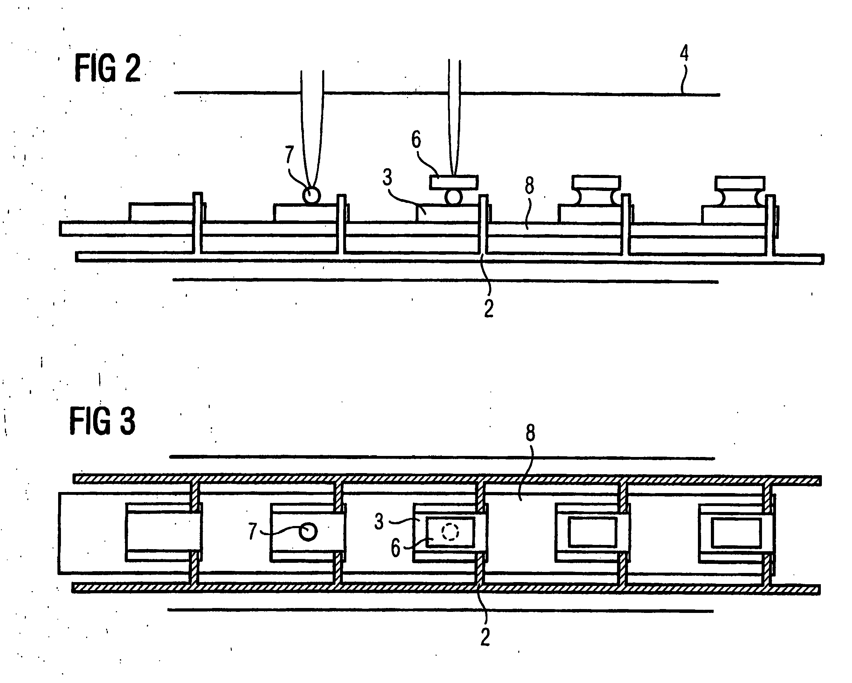

In Figur 2 ist eine Prozeßanlage für Montage von Einzelleadframes gemäß dem Stand der Technik dargestellt. Der Leadframe 3 ist auf einer Arbeitsplatte 8 angeordnet und wird von einer Halterung 2 gehalten. Weiterhin wird der Leadframe 3 von der Halterung 2 auf der Arbeitsplatte 8 verschoben. Mit einer geeigneten Vorrichtung wird ein Verbindungsmittel 7 auf den Leadframe 3 aufgebracht. Innerhalb der Temperaturkammer 4 wird das elektrische Bauelement 6 mit Hilfe des Verbindungsmittels 7 mit dem Leadframe 3 verbunden.

Mit Bezug auf Figur 3 ist die Draufsicht auf die Montageprozeßanlage aus Figur 2 dargestellt. Der Leadframe 3 befindet sich auf der Arbeitsplatte 8 und wird von der Halterung 2 gehalten. Auf dem Leadframe 3 befindet sich ein Verbindungsmittel 7, welches in der Temperaturkammer dazu dient, das elektrische Bauelement 6 mit dem Leadframe 3 zu verbinden

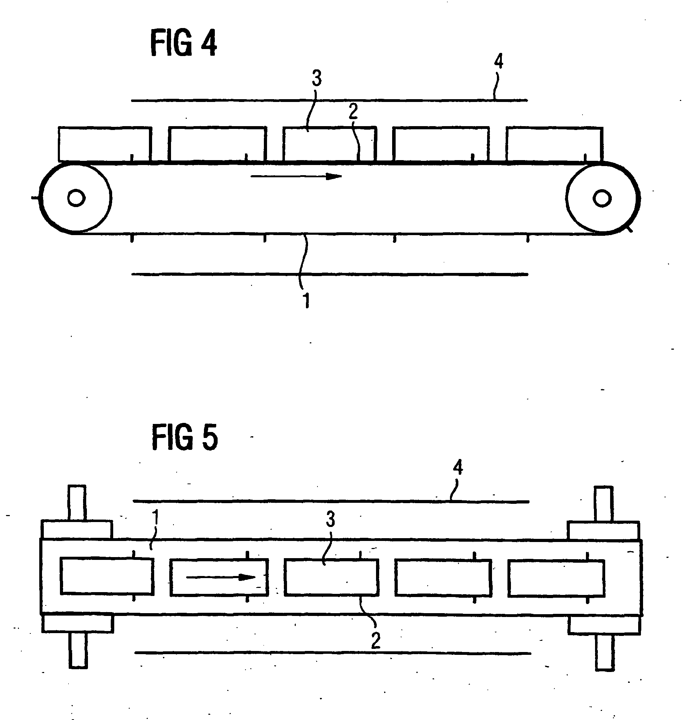

In Figur 4 ist ein Ausführungsbeispiel einer erfindungsgemäßen Montageprozeßanlage zur Verarbeitung von Einzelleadframes dargestellt. Sie besteht aus einem Endlostransportband 1, auf dem eine Halterung 2 angeordnet ist. An der Halterung 2 ist der Leadframe 3 justiert und befestigt. Mit Hilfe des Transportbandes 1 wird der Leadframe 3 durch die Temperaturkammer 4 transportiert.

In Figur 5 ist die Draufsicht auf das Ausführungsbeispiel aus Figur 4 dargestellt. Dabei befindet sich der Leadframe 3 auf dem Transportband 1, wobei der Leadframe 3 an der Halterung 2 justiert ist. Weiterhin dient die Halterung 2 dazu, den Leadframe 3 mit dem Transportband 1 zu verbinden.

### Bezugszeichenliste

- 1: Endlostransportband
- 2: Halterung
- 3: Leadframe
- 4: Temperaturkammer
- 5: Loch
- 6: Bauelement
- 7: Verbindungsmittel
- 8: Arbeitsplatte
- 9: elektrischer Kontakt

## Patentansprüche

1. Eine Prozeßanordnung zur Montage von elektronischen Bauelementen auf Leadframes mit:
- einem Endlostransportband (1);
- Bearbeitungsstationen zum Verbinden des Leadframes (3) mit einem Bauelement (6) und zum elektrischen Kontaktieren des Leadframes (3) mit einem Bauelement (6) wobei die Bearbeitungsstationen an dem Endlostransportband (1) angeordnet sind;
- einer Halterung (2), die an dem Endlostransportband (1) befestigt ist, und die zum Justieren und Arretieren eines Leadframes auf dem Endlostransportband (1) ist; und
- einem Leadframe (3), der auf dem Endlostransportband (1) angeordnet ist und an der Halterung justiert und arretiert ist, so daß der an der Halterung justierte und arretierte Leadframe (3) die Bearbeitungsstationen durchlaufen kann.

2. Eine Prozeßanordnung nach Anspruch 1,
**dadurch gekennzeichnet, daß**
das Endlostransportband (1) zumindest teilweise in einer Temperaturkammer (4) angeordnet ist.

3. Eine Prozeßanordnung nach einem der Ansprüche 1 oder 2,
**dadurch gekennzeichnet, daß**
in dem Leadframe (3) ein Loch (5) angeordnet ist, an dem die Halterung (2) justiert und/oder befestigt ist.

4. Eine Prozeßanordnung nach einem der Ansprüche 1 bis 3,
**dadurch gekennzeichnet, daß**
die Halterung (2) aus einem Stift besteht, auf dem der Leadframe (3) aufgesteckt wird.

5. Ein Prozeßverfahren mit dem Schritt:
Bereitstellen einer Prozeßanordnung mit Bearbeitungsstationen zum Verbinden eines Leadframes (3) mit einem Bauelement (6) und zum elektrischen Kontaktieren des Leadframes (3) mit einem Bauelement (6), einem Endlostransportband (1) und einer Halterung (2), die an dem Endlostransportband (1) befestigt ist und die zum Justieren und Arretieren eines Leadframes auf dem Endlostransportband (1) ist,
und mit den weiteren Schritten:
- Auflegen eines Leadframes (3) auf das Endlostransportband (1),
- Justieren und Arretieren des Leadframes (3) auf dem Endlostransportband durch die Halterung, und
- Befördern des an der Halterung Justierten und arretierten Leadframes (3) durch die Bearbeitungsstationen.

6. Prozeßverfahren nach Anspruch 5,
**dadurch gekennzeichnet, daß**
das Endlostransportband (1) mit dem aufgelegten Leadframe (3) eine Temperaturkammer (4) durchläuft.

7. Prozeßverfahren nach Anspruch 6,
**dadurch gekennzeichnet, daß**
ein Verbindungsmittel (7) auf dem Leadframe (3) aufgebracht wird.

8. Prozeßverfahren nach Anspruch 7,
**dadurch gekennzeichnet, daß**
in der Temperaturkammer (4) ein Bauelement (6) mit Hilfe des Verbindungsmittels (7) mit dem Leadframe (3) verbunden wird.

9. Prozeßverfahren nach einem der Ansprüche 5 bis 7,
**dadurch gekennzeichnet, daß**
das Endlostransportband (1) um eine frei wählbare Strecke verfahren wird.

10. Ein Prozeßverfahren nach einem der Ansprüche 5 bis 9
**dadurch gekennzeichnet, daß**
der Leadframe (3) mit einem Bauelement (6) elektrisch verbunden wird.

11. Prozeßverfahren nach einem der Ansprüche 5 bis 10,
**dadurch gekennzeichnet, daß**
in dem Leadframe (3) ein Loch (5) angeordnet ist, an dem die Halterung (2) justiert und/oder befestigt wird.

## Claims

1. Process arrangement for assembly of electronic components on leadframes having:
- an endless conveyor belt (1);
- processing stations for connection of the leadframe (3) to a component (6) and for making electrical contact between the leadframe (3) and a component (6), with the processing stations being arranged on the endless conveyor belt (1);
- a holder (2), which is attached to the endless conveyor belt (1) and is intended for adjustment and locking of a leadframe on the endless conveyor belt (1); and
- a leadframe (3), which is arranged on the endless conveyor belt (1) and is adjusted and locked on the holder such that the leadframe (3) which is adjusted and locked on the holder can pass through the processing stations.

2. Process arrangement according to Claim 1,
**characterized**
**in that** at least part of the endless conveyor belt (1) is arranged in a temperature chamber (4).

3. Process arrangement according to one of Claims 1 or 2,
**characterized**
**in that** a hole (5) on which the holder (2) is adjusted and/or to which said holder (2) is attached is arranged in the leadframe (3).

4. Process arrangement according to one of Claims 1 to 3,
**characterized**
**in that** the holder (2) comprises a pin on which the leadframe (3) is plugged.

5. Process method having the following step:
provision of a process arrangement having processing
stations for connection of a leadframe (3) to a
component (6) and for making electrical contact between the leadframe (3) and a component (6), an endless conveyor belt (1) and a holder (2) which is attached to the endless conveyor belt (1), and is intended for adjustment and locking of a leadframe on the endless conveyor belt (1),
and having the further steps of:
- placing of a leadframe (3) on the endless conveyor belt (1),
- adjustment and locking of the leadframe (3) on the endless conveyor belt by means of the holder, and
- conveying of the leadframe (3), which has been adjusted and locked on the holder, through the processing stations.

6. Process method according to Claim 5,
**characterized**
**in that** the endless conveyor belt (1), together with the leadframe (3) placed on it, passes through a temperature chamber (4).

7. Process method according to Claim 6,
**characterized**
**in that** a connection means (7) is mounted on the leadframe (3).

8. Process method according to Claim 7,
**characterized**
**in that**, in the temperature chamber (4), a component (6) is connected to the leadframe (3) with the aid of the connection means (7).

9. Process method according to one of Claims 5 to 7,
**characterized**
**in that** the endless conveyor belt (1) is moved through a freely variable distance.

10. Process method according to one of Claims 5 to 9,
**characterized**
**in that** the leadframe (3) is electrically connected to a component (6).

11. Process method according to one of Claims 5 to 10,
**characterized**
**in that** a hole (5) on which the holder (2) is adjusted and/or to which said holder (2) is attached is arranged in the leadframe (3).

## Revendications

1. Dispositif de montage de composants électroniques sur des leadframes comprenant :
- une bande (1) convoyeuse sans fin ;
- des postes de traitement pour relier le leadframe (3) à un composant (6) et pour mettre en contact électrique le leadframe (3) avec un composant (6), les postes de traitement étant disposés sur la bande (1) convoyeuse sans fin ;
- une fixation (2) qui est fixée sur la bande (1) convoyeuse sans fin et qui est destinée à ajuster et à bloquer un leadframe sur la bande (1) convoyeuse sans fin ; et
- un leadframe (3) qui est disposé sur la bande (1) convoyeuse sans fin et qui est ajusté et bloqué sur la fixation de façon à ce que le leadframe ajusté et bloqué sur la fixation puisse passer dans les postes de traitement.

2. Dispositif suivant la revendication 1,
**caractérisé en ce que**
la bande (1) convoyeuse sans fin est disposée au moins en partie dans une chambre (4) de mise en température.

3. Dispositif suivant l'une des revendications 1 ou 2,
**caractérisé en ce que**
il est pratiqué dans le leadframe (3) un trou (5) sur lequel la fixation (2) est ajustée et/ou fixée.

4. Dispositif suivant l'une des revendications 1 à 3,
**caractérisé en ce que** la fixation (2) est constituée d'une broche sur lequel le leadframe (3) est enfilé.

5. Procédé de montage comprenant les stades :
on se procure un dispositif de montage ayant des postes de traitement pour relier un leadframe (3) à un composant (6) et pour la mise en contact électrique du leadframe (3) avec un composant (6), une bande (1) convoyeuse sans fin et une fixation (2) qui est fixée à la bande (1) convoyeuse sans fin et qui est destinée à ajuster et à bloquer un leadframe sur la bande (1) convoyeuse sans fin, et ayant en outre les stades dans lesquels
- on met un leadframe (3) sur la bande (1) convoyeuse sans fin,
- on ajuste et on bloque le leadframe (3) sur la bande convoyeuse sans fin par la fixation, et
- on transporte le leadframe (3) ajusté et bloqué par la fixation dans les postes de traitement.

6. Procédé suivant la revendication 5,
**caractérisé en ce que**
la bande (1) convoyeuse sans fin passe avec le leadframe (3) qui y est posé dans une chambre (4) de mise en température.

7. Procédé suivant la revendication 6,
**caractérisé en ce que**
un agent (7) de liaison est déposé sur le leadframe (3).

8. Procédé suivant la revendication 7,
**caractérisé en ce que**
dans la chambre (4) de mise en température un composant (6) est relié au leadframe (3) à l'aide de l'agent (7) de liaison.

9. Procédé suivant l'une des revendications 5 à 7,
**caractérisé en ce que**
la bande (1) convoyeuse sans fin se déplace d'une longueur pouvant être choisie librement.

10. Procédé suivant l'une des revendications 5 à 9,
**caractérisé en ce que**
l'on relie électriquement le leadframe (3) à un composant (6).

11. Procédé suivant l'une des revendications 5 à 10,
**caractérisé en ce que**
l'on ménage dans le leadframe (3) un trou (5) dans lequel la fixation (2) est ajustée et/ou fixée.
